(19) Europäisches Patentamt
European Patent Office
Office européen des brevets

(11) **EP 2 187 494 B1**

(12) **EUROPÄISCHE PATENTSCHRIFT**

(45) Veröffentlichungstag und Bekanntmachung des Hinweises auf die Patenterteilung:
**01.08.2012 Patentblatt 2012/31**

(51) Int Cl.:
*H02H 7/085* (2006.01)    *H02H 9/02* (2006.01)
*G01R 31/34* (2006.01)    *H02H 5/04* (2006.01)

(21) Anmeldenummer: **09173817.9**

(22) Anmeldetag: **22.10.2009**

(54) **Schutzeinrichtung für elektrische Motoren**

Protection device for electric motors

Dispositif de protection pour moteurs électriques

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **13.11.2008 DE 102008057070**

(43) Veröffentlichungstag der Anmeldung:
**19.05.2010 Patentblatt 2010/20**

(73) Patentinhaber: **KRIWAN INDUSTRIE-ELEKTRONIK GMBH**
**74670 Forchtenberg (DE)**

(72) Erfinder:
• **Kriwan, Friedrich**
**74670 Forchtenberg (DE)**
• **Peng, Xiaoming**
**74613 Öhringen (DE)**

(74) Vertreter: **Tetzner, Michael et al**
**Van-Gogh-Strasse 3**
**81479 München (DE)**

(56) Entgegenhaltungen:
**US-A- 3 644 864**

**Beschreibung**

Die Erfindung betrifft eine Schutzeinrichtung für elektrische Motoren mit einem einer Sensorschaltung und einem Auslösegerät.

Derartige Schutzeinrichtungen kommen beispielsweise bei hoch ausgenutzten Kält-Verdichtermotoren zur Überwachung der thermischen Überlastung zur Anwendung.

Elektromotoren unterliegen der Gefahr der Überhitzung der Motorwicklung, wobei Überlastungen, schlechte Netzqualitäten (Unterspannung/Überspannung), eine behinderte Kühlung, ein blockierter Läufer und dergleichen zu den häufigsten Ausfallursachen zählen. Motoren, insbesondere Kälte-Verdichtermotoren, die hoch ausgenutzt sind und deshalb einer Zwangskühlung unterliegen, müssen vor solchen Gefahren geschützt werden.

Stromrelais oder Bimetallschalter können diese Aufgabe jedoch nicht zuverlässig erfüllen. In der DE 195 40 625 B4 wurde daher eine Thermistor-Schutzschaltung mit mehreren PTC-Sensoren vorgeschlagen, wobei die PTC-Sensoren in der Motorwicklung eingebaut und in Reihe geschaltet wurden.

Die DE 198 22 056 A1 offenbart eine weitere Temperaturschutzschaltung zum Schutz elektrischer Geräte mit einer Reihenschaltung von PTC-Thermistoren abgestufter Nennansprechtemperatur.

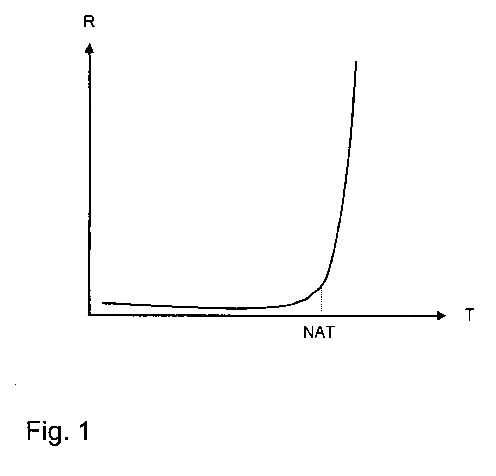

PTC-Thermistoren besitzt typischerweise eine Kennlinie, wie sie im Fig. 1 dargestellt ist. Von Raumtemperatur bis wenige C° unterhalb der Nennabschalttemperatur NAT ist die Kennlinie flach und steigt dann exponentiell an. Eine Aussage über die Wicklungstemperatur ist mit solchen PTC-Thermistoren nicht möglich. Jedoch lässt sich die Veränderung des Widerstandswertes im Bereich der Nennabschalttemperatur NAT von einer Auswertungseinrichtung eines Auslösegerätes erfassen. Der Abschaltvorgang des Motors wird dann ausgelöst, wenn die Auswertungseinrichtung eine Überschreitung der Nennansprechtemperatur NAT feststellt.

Aus der US 3 644 864 A ist eine Schutzeinrichtung gemäß dem Oberbegriff des Anspruchs 1 bekannt, die eine Sensorschaltung mit zwei Thermistorelementen mit unterschiedlich großen Nennansprechtemperaturen und ein Auslösegerät mit einer Auswertungseinrichtung umfasst. Die beiden Thermistorelemente sind so miteinander verschaltet, dass der Gesamtwiderstand der Sensorschaltung eine Kennlinie aufweist, die im Bereich der Nennansprechtemperaturen jeweils einen Wendepunkt vorsieht.

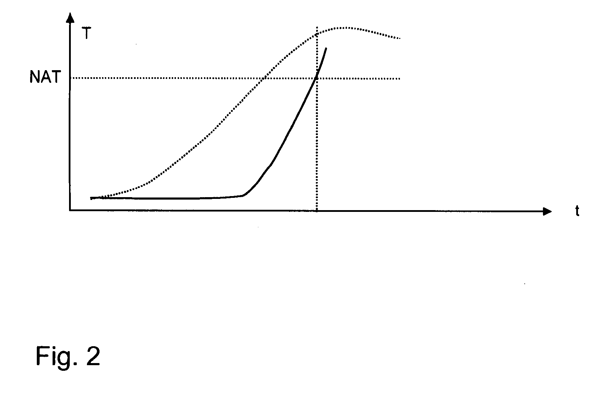

Obwohl PTC-Sensoren sehr klein sind, können sie aufgrund der thermischen Übergangswiderstände zwischen Sensor und Wicklung dem sehr raschen Temperaturanstieg nur verzögert folgen. Bei Kälteverdichtermotoren mit Wicklungsstromdichten bis 80 A/mm$^2$ steigen im Kurzschlussfall die Temperaturen mit 25 bis 30 K/s an. Dies bedeutet, dass bereits Abschaltverzögerungen von wenigen Sekunden einen sehr hohen Temperaturüberlauf erzeugen können, wie das aus Fig. 2 ersichtlich wird. Die gestrichelte Linie stellt dabei die erfasste Temperatur und die durchgezogene Linie die tatsächliche Wicklungstemperatur dar. Die Abschaltung erfolgt erst dann, wenn die erfasste Temperatur die Nennansprechtemperatur erreicht hat. Zu diesem Zeitpunkt liegt die tatsächliche Wicklungstemperatur jedoch schon deutlich über dem vorgegebenen Schwellenwert.

Der Erfindung liegt daher die Aufgabe zugrunde eine Schutzeinrichtung für elektrische Motoren anzugeben, mit der ein gefährlicher Temperaturüberlauf vermieden werden kann.

Erfindungsgemäß wird diese Aufgabe durch die Merkmale des Anspruches 1 gelöst.

Die erfindungsgemäße Schutzeinrichtung für elektrische Motoren besteht im Wesentlichen aus

-   einer Sensorschaltung (2) mit wenigstens einem ersten PTC-Sensor (PTC1), wenigstens einem zweiten PTC-Sensor (PTC2), dessen Nennansprechtemperatur (NAT2) größer als die Nennansprechtemperatur (NAT1) des ersten PTC-Sensors ist, sowie
-   einem Auslösegerät (3) mit einer Auswertungseinrichtung zur Auswertung des sich aufgrund des Gesamtwiderstandes der Sensorschaltung ergebenden Sensorsignals und zur Erzeugung eines Ausgangssignals für das Auslösegerät in Abhängigkeit des Sensorsignals, wobei die Auswertungseinrichtung Mittel zur Ermittlung der Ableitung zweiter Ordnung des zeitabhängigen Sensorsignals ($d^2T/dt^2$, $d^2R/dt^2$, $d^2V/dt^2$) umfasst und ein Ausgangssignal generiert, wenn die Ableitung zweiter Ordnung des zeitabhängigen Sensorsignals einen vorgegebenen Schwellenwert überschreitet.

Die beiden PTC-Sensoren sind dabei so miteinander verschaltet, dass der Gesamtwiderstand der Sensorschaltung eine Kennlinie aufweist, die im Bereich der Nennansprechtemperaturen jeweils einen Wendepunkt vorsieht.

Unter einem Wendepunkt ist im Sinne der Erfindung ein Punkt auf der Kennlinie zu verstehen, an welchem die Kennlinie ihr Krümmungsverhalten ändert. Die Kennlinie wechselt hier entweder von einer Rechts- in eine Linkskurve oder umgekehrt. Der zweite Wendpunkt wird sich kurz vor der zweiten Nennansprechtemperatur ausbilden.

Mit einer derartigen Kennlinie lässt sich das Erreichen einer kritischen Situation noch schneller erfassen. Es sind daher Mittel vorgesehen, welche die Bereiche der Wendepunkte der Kennlinie auswerten und durch Mittel zur Ermittlung der Ableitung zweiter Ordnung des zeitabhängigen Sensorsignals ($d^2T/dt^2$, $d^2R/dt^2$, $d^2V/dt^2$) gebildet werden. Die Ableitung zweiter Ordnung spiegelt die Beschleunigung bzw. die Krümmungsänderung des Sensorsignals wieder.

Bei den bisherigen PTC-Sensorschaltungen konnte das Erreichen der Auslöseschwelle erst im Bereich des exponentiellen Anstiegs festgestellt werden. Da jedoch die Temperatur bei hohen Stromdichten innerhalb weniger Sekunden drastisch ansteigen kann, ist eine möglichst frühzeitige Erkennung einer vorgegeben Schwelle für den Schutz und die Lebensdauer des zu überwachenden Motors entscheidend.

Gemäß einem ersten Ausführungsbeispiel werden die Wendepunkte durch Einbindung eines Festwiderstandes erzeugt. Der Festwiderstand wird dabei vorzugsweise parallel zum ersten PTC-Sensor geschaltet. Gemäß einer weiteren Ausgestaltung ist der Festwiderstand außerdem in Reihe zum zweiten PTC-Sensor angeordnet. Die beiden PTC-Sensoren können wahlweise in Reihe oder parallel geschaltet werden. Weiterhin kann vorgesehen werden, dass zwei, vorzugsweise drei oder mehr erste PTC-Sensoren und wenigstens zwei, vorzugsweise drei oder mehr zweite PTC-Sensoren parallel oder in Reihe geschaltet werden.

Gemäß einer weiteren Ausgestaltung der Erfindung kann auch ein dritter oder weitere PTC-Sensoren vorgesehen werden, die unterschiedliche Nennansprechtemperaturen, insbesondere größere Nennansprechtemperatur als der erste und zweite PTC-Sensor aufweisen, um eine mehrstufige Temperaturüberwachung zu ermöglichen.

Die Kennlinie weist zwischen den beiden Wendepunkten einen annähernd linear ansteigenden Verlauf auf, der von der Auswertungseinrichtung zusätzlich ausgewertet werden kann.

Die Auswertungseinrichtung ist so konfiguriert, dass sie ein Ausgangssignal generiert, wenn das Sensorsignal einen vorgegebenen Schwellenwert überschreitet. Dabei können beim Erreichen der beiden Nennansprechtemperaturen unterschiedliche Ausgangssignale erzeugt werden, die entsprechend unterschiedliche Maßnahme zur Folge haben.

Gemäß einer weiteren Ausgestaltung der Erfindung weist die Auswertungseinrichtung Mittel zur Ermittlung der Ableitung erster Ordnung des zeitabhängigen Sensorsignals (dT/dt, dR/dt, dV/dt) auf. Die Ableitung erster Ordnung des Sensorsignals entspricht der Steigung der Kennlinie.

Es besteht somit neben der üblichen Schwellenwertüberwachung über die Nennansprechtemperaturen auch die Möglichkeit, Schwellenwerte für die überwachten Wicklungsstromdichten festzulegen und bei einer Überschreitung entsprechend zu reagieren. Ein Temperaturüberlauf kann dadurch frühzeitig erkannt und gegebenenfalls vermieden werden.

Weitere Vorteile und Ausgestaltungen der Erfindung werden im Folgenden anhand der Beschreibung und der Zeichnung näher erläutert.

In der Zeichnung zeigen

Fig. 1 eine Kennlinie eines PTC-Sensors,

Fig. 2 eine Darstellung der tatsächlichen Wicklungstemperatur im Vergleich zur erfassten Temperatur,

Fig. 3 eine schematische Darstellung der Schutzschaltung,

Fig. 4a + 4b zwei Varianten einer Sensorschaltung mit einem ersten PTC-Sensor, einem zweiten PTC-Sensor und einem Festwiderstand,

Fig. 4c eine Kennlinie des gesamten Widerstands der in den Fig. 4a gezeigten Sensorschaltung,

Fig. 5a - 5c verschiedene Schaltungsvarianten mit drei ersten und drei zweiten PTC-Sensoren und wenigstens einem Festwiderstand,

Fig. 6a eine Sensorschaltung mit drei unterschiedlichen PTC-Sensoren,

Fig. 6b eine Kennlinie des Gesamtwiderstands der in Fig. 6a gezeigten Sensorschaltung,

Fig. 7a eine Sensorschaltung mit zwei PTC-Sensoren, die unterschiedliche Kaltwiderstandswerte aufweisen,

Fig. 7b eine Kennlinie des Gesamtwiderstandes der in Fig. 7a gezeigten Sensorschaltung,

Fig. 8 eine Sensorschaltung gemäß Fig. 4a mit Spannungsteiler,

Fig. 9 Darstellung der erfassten Temperatur im Vergleich zur tatsächlichen Wicklungstemperatur für verschiedene Stromstärken,

Fig. 10 Darstellung der Auswertung des Sensorsignals in Abhängigkeit der Ableitung erster Ordnung und

Fig. 11          Darstellung der Auswertung des Sensorsignals in Abhängigkeit der Ableitung zweiter Ordnung.

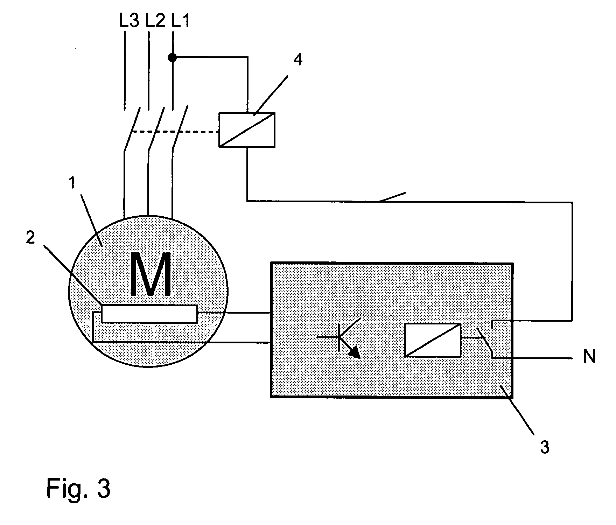

Die in Fig. 3 dargestellte Schutzeinrichtung für einen elektrischen Motor 1 umfasst eine Sensorschaltung 2 sowie ein Auslösegerät 3, wobei das Auslösegerät eine Auswertungseinrichtung aufweist, die zur Auswertung des sich aufgrund des Gesamtwiderstandes der Sensorschaltung ergebenen Sensorsignals und zur Erzeugung des Ausgangssignals für das Auslösegerät in Abhängigkeit des Sensorssignals ausgebildet ist. Das Ausgangssignal kann beispielsweise zur Steuerung eines Schützes 4 verwendet werden, um die Stromzufuhr des Motors 1 zu unterbrechen.

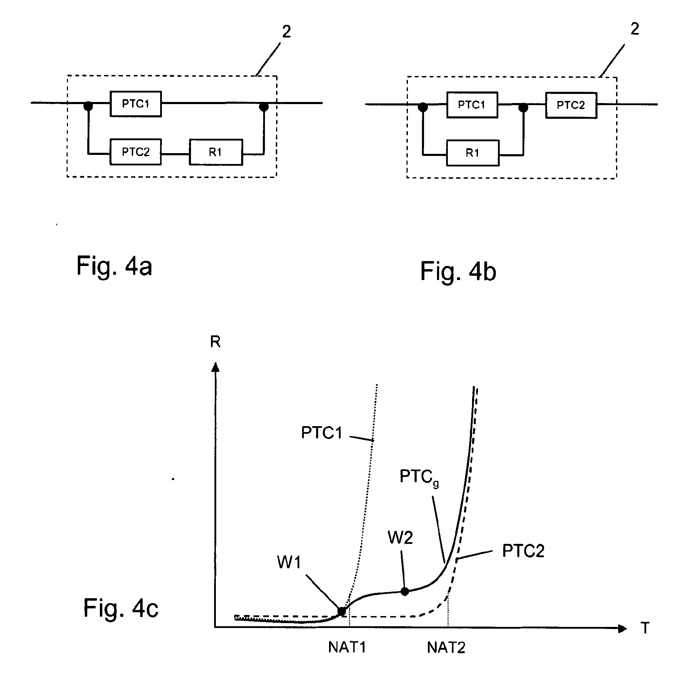

Die in Fig. 4a gezeigte Sensorschaltung weist einen ersten PTC-Sensor PTC1 und einen zweiten PTC-Sensor PTC2 sowie einen Festwiderstand R1 auf. Die beiden PTC-Sensoren sind parallel geschaltet, während der Festwiderstand R1 in Reihe zum zweiten PTC-Sensor PTC2 und zum parallel zum ersten PTC-Sensor PTC1 angeordnet ist.

In der Ausführungsvariante der Sensorschaltung gemäß Fig. 4b ist wiederum der Festwiderstand R1 parallel zum ersten PTC-Sensor PTC1 angeordnet, während jedoch der zweite PTC-Sensor PTC2 in Reihe zum ersten PTC- Sensor PTC1 vorgesehen ist.

Die Kennlinien der beiden PTC-Sensoren PTC1 und PTC2 entsprechen beispielsweise der DIN 44081. Sie erzeugen durch die Serien- oder Parallelschaltung gemäß den Figuren 4a und 4b die Kennlinie des Gesamtwiderstands $PTC_g$.

In Fig. 4c sind die Widerstandskennlinien der beiden PTC-Sensoren gestrichelt bzw. gepunktet eingezeichnet. Des gestufte Kennlinie $PTC_g$ stellt den Gesamtwiderstand dar.

Der Gesamtwiderstand $PTC_g$ der Sensorschaltung gemäß Fig. 4a ergibt sich aus

$$PTC_g = \frac{PTC_1 \bullet (PTC_2 + R_1)}{PTC_1 + PTC_2 + R_1} \qquad\qquad (1)$$

Im Bereich PTC1 << R1 und PTC2 « R1 gilt nach (1):

$$PTC_g \approx \frac{PTC_1 \bullet R_1}{R_1} = PTC_1 \qquad\qquad (2)$$

PTC1 bestimmt somit in diesem Bereich fast ausschließlich den Verlauf der Kennlinie $PTC_g$. Die Temperatur in diesem Bereich lässt sich somit über (2) und die Kennlinie von PTC1 ermitteln.

Liegt PTC1 im Wertebereich von R1 und PTC2 « R1, gilt nach (1)

$$PTC_g \approx \frac{PTC_1 \bullet R_1}{PTC_1 + R_1} \qquad\qquad (3)$$

Diese entspricht eine Parallelschaltung von PTC 1 und R1. Die Widerstandsveränderung von PTC 1 bestimmt in diesem Bereich die Widerstandsveränderung von $PTC_g$, da R1 einen festen Wert besitzt. Die Temperatur in diesem Bereich lässt sich somit über (3) und die Kennlinie von PTC1 ermitteln.

Im Bereich PTC1 » (PTC2 + R1) gilt nach (1)

$$PTC_g \approx \frac{PTC_1 \bullet (PTC_2 + R_1)}{PTC_1} = PTC_2 + R_1 \qquad\qquad (4)$$

Dies entspricht einer Reihenschaltung von PTC2 und R1. Die Widerstandsveränderung von PTC2 bestimmt in diesem Bereich die Widerstandsveränderung von $PTC_g$, da R1 einen festen Wert besitzt. Die Temperatur in diesem Bereich lässt sich somit über (4) und die Kennlinie von PTC2 ermitteln.

Die Besonderheit der Kennlinie PTCg besteht darin, dass im Bereich der beiden Nennansprechtemperaturen NAT1 und NAT2 Wendepunkte W1 und W2 vorgesehen sind, welche nach wie vor zwei Schaltpunkte für das Auslösegerät 3 widerspiegeln.

Die Kennlinie PTCg weist im Bereich unterhalb der Nennansprechtemperatur NAT1 einen niederohmigen und flachen Kennlinienverlauf, wie ein einzelner PTC-Sensor auf. Im Bereich um die Nennansprechtemperatur NAT1 hat die Sensorschaltung dennoch eine vergleichbare Auflösung wie ein einzelner PTC-Sensor. Dieser Bereich kann beispielsweise für einen Locked-Rotor-Schutz sehr effektiv genutzt werden, ohne die Abschaltgrenze beim Normalbetrieb zu beeinflussen. Der Temperaturbereich zwischen den beiden Nennansprechtemperaturen NAT1 und NAT2 kann aufgrund des annähernd linear ansteigenden Verlaufs beispielsweise für Diagnosefunktionen genutzt werden. Auch die Rückschalthysterese lässt sich ohne zusätzlichen Mehraufwand vergrößern. Im Bereich um die Nennansprechtemperatur NAT2 hat die Sensorschaltung wiederum eine vergleichbare Auflösung wie ein einzelner PTC-Sensor. Dieser Bereich kann insbesondere zur Überwachung der Motorüberlastung genutzt werden.

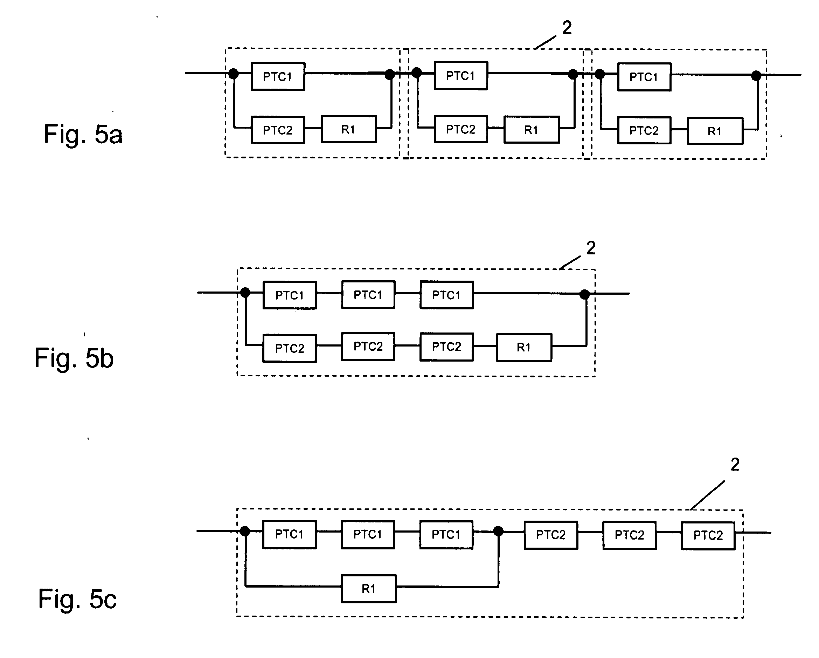

In den Fig. 5a bis 5c sind weitere Schaltungsvarianten aufgezeigt, die jeweils drei erste PTC-Sensoren PTC1 und drei zweite PTC-Sensoren PTC2 aufweisen. Zweckmäßigerweise wird jeweils ein erster und ein zweiter PTC-Sensor in einer der drei Wicklungsphasen des zu überwachenden Motors eingebaut. Welches der selbsterklärenden Ausführungsbeispiele zweckmäßigerweise zur Anwendung kommt, hängt insbesondere vom Fertigungsverfahren der Sensoren und der Konfektionierung und Anbringung der Sensoren in der Anwendung ab.

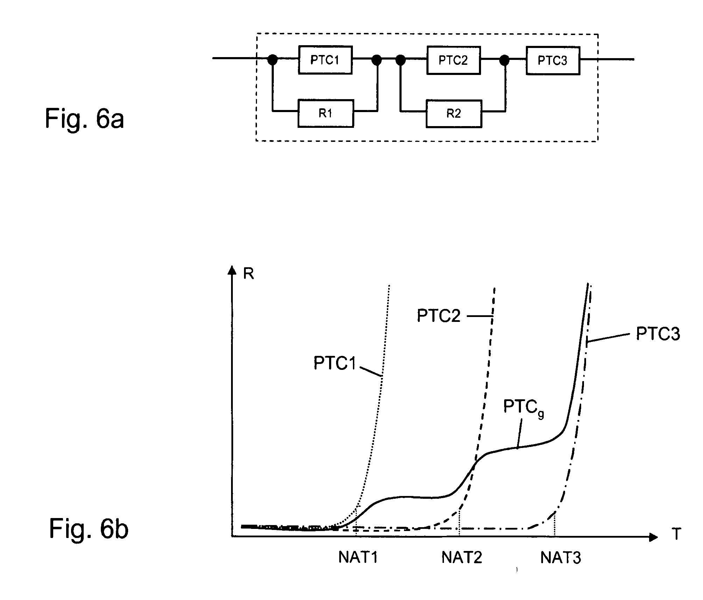

Selbstverständlich können auch mehr als zwei unterschiedliche PTC-Sensoren verwendet werden. Im Ausführungsbeispielen gemäß den Fig. 6a und 6b sind drei PTC-Sensoren PTC1, PTC2 und PTC3 vorgesehen, die jeweils unterschiedliche Nennansprechtemperaturen NAT1, NAT2 und NAT3 aufweisen. Die drei PTC-Sensoren sind in Reihe geschaltet, wobei ein erster Festwiderstand R1 parallel zum ersten PTC-Sensor PTC1 und ein zweiter Festwiderstand R2 parallel zum zweiten PTC-Sensor PTC2 angeordnet ist. Gemäß Fig. 6b ergibt sich eine Kennlinie PTCg der Sensorschaltung, die wiederum gestuft ausgebildet ist und nun drei Wendepunkte aufweist.

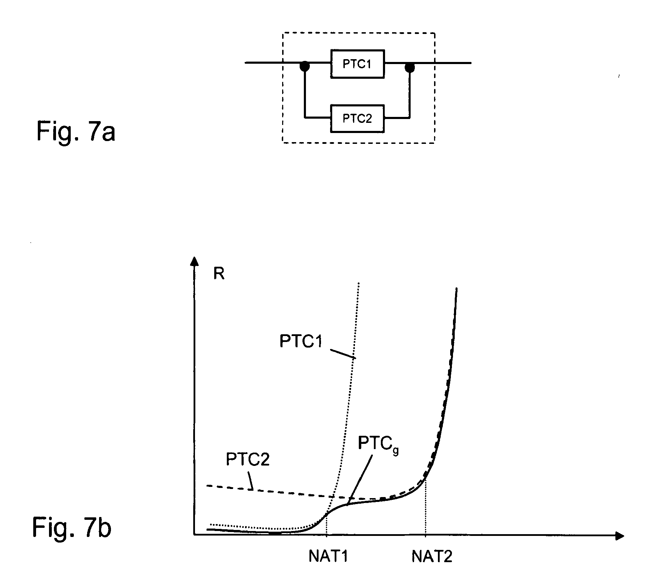

In der Sensorschaltung kann auf den Festwiderstand aber auch verzichtet werden, wenn die wenigstens zwei PTC-Sensoren PTC1, PTC2 parallel geschaltet sind und der zweite PTC-Sensor einen höheren Kaltwiderstandswert als der erste PTC-Sensor aufweist, wie dies in den Fig. 7a und 7b dargestellt ist.

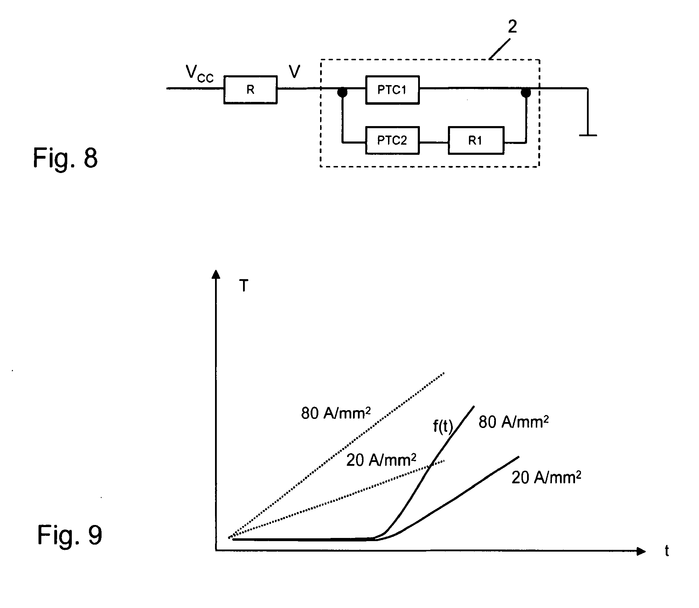

Zur Umwandlung des Sensorsignals, um es anschließend im Auslösegerät auszuwerten, kann beispielsweise der in Fig. 8 dargestellte Spannungsteiler verwendet werden.

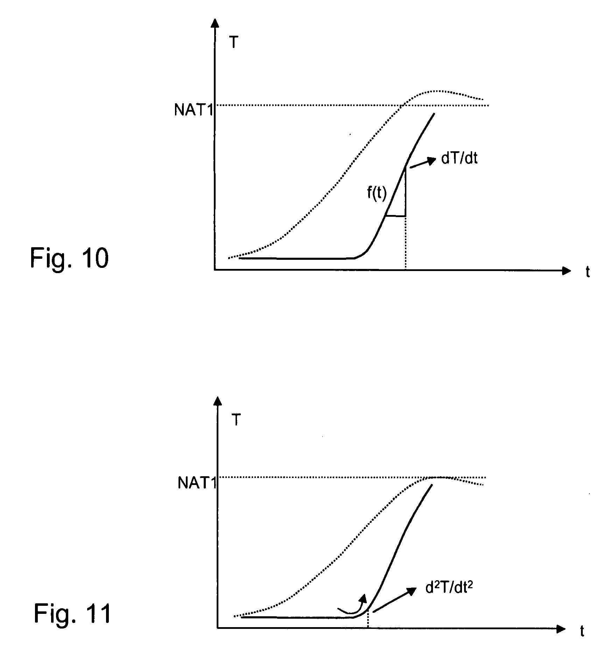

In Fig. 9 ist der tatsächliche Temperaturanstieg der Wicklung und die erfasste Temperatur bei unterschiedliche Stromstärken dargestellt. Hieraus wird ersichtlich, dass die Steigung ein Maß für die Stromstärke ist. Bei einer sehr hohen Stromstärke, die beispielsweise im Kurzschlussfall auftritt, kann die Temperatur beispielsweise um 25 bis 30 K/s ansteigen. Gemäß einer besonderen Ausgestaltung der Erfindung weist die Auswertungseinrichtung daher Mittel zur Ermittlung der Ableitung erster Ordnung des zeitabhängigen Sensorsignals (dT/dt, dR/dt, dV/dt) auf. Die Ableitung erster Ordnung des Sensorsignals entspricht der Steigung, wie dies in Fig. 10 dargestellt ist. Auf diese Weise kann ein entsprechendes Ausgangssignal bereits ausgelöst werden, bevor die erfasste Temperatur die Nennansprechtemperatur erreicht.

Eine noch schnellere Erfassung einer kritischen Situation ist dann gegeben, wenn Mittel zur Ermittlung der Ableitung zweiter Ordnung des zeitabhängigen Sensorsignals ($d^2T/dt^2$, $d^2R/dt^2$, $d^2V/dt^2$) vorgesehen sind. Die Ableitung zweiter Ordnung spiegelt die Beschleunigung bzw. die Krümmungsänderung des Sensorsignals wieder. Wie aus Fig. 11 ersichtlich wird, kann somit ein entsprechendes Ausgangssignal noch etwas eher erzeugt werden.

Es besteht somit neben der üblichen Schwellenwertüberwachung mit den Nennansprechtemperaturen auch die Möglichkeit Grenzwerte für die überwachten Wicklungsstromdichten festzulegen und bei einer Überschreitung entsprechend zu reagieren. Ein Temperaturüberlauf kann dadurch frühzeitig erkannt und gegebenenfalls vermieden werden.

Die oben beschriebene Schaltung kann somit für eine statische Schwellenwertüberwachung mittels der Nennansprechtemperaturen als auch für eine dynamische Temperaturüberwachung im Falle eines raschen Anstiegs der zu überwachenden Temperatur eingesetzt werden. Man erhält dadurch einen unabhängigen und individuell definierbaren, dynamischen und statischen Schutz des Motors. Der dynamische Schutz mittels der Ableitung erster oder zweiter Ordnung schützt vor raschen Temperaturanstiegen, beispielsweise infolge eines blockierten Rotors und der statische Schutz mit einem Schwellenwert (Nennansprechtemperaturen) schützt vor einer Betriebsüberlastung. Somit ist ein effektiver Schutz bei einem blockierten Rotor ohne Einschränkung des normalen Auslastungsgrades erreichbar. Die erzielte effektive Schutz bei einem blockierten Rotor und die unabhängigen, individuell definierbaren, dynamischen und statischen Schutzkriterien ermöglichen außerdem eine weitere Steigerung des Auslastungsgrades des Motors und/oder die Einsparung des aktiven Materials (Kupfer und Eisen).

**Patentansprüche**

1.  Schutzeinrichtung für elektrische Motoren (1) mit

    - einer Sensorschaltung (2) mit wenigstens einem ersten PTC-Sensor (PTC1), wenigstens einem zweiten PTC-Sensor (PTC2), dessen Nennansprechtemperatur (NAT2) größer als die Nennansprechtemperatur (NAT1) des ersten PTC-Sensors ist, sowie

- einem Auslösegerät (3) mit einer Auswertungseinrichtung zur Auswertung des sich aufgrund des Gesamtwiderstandes der Sensorschaltung ergebenden Sensorsignals und zur Erzeugung eines Ausgangssignals für das Auslösegerät in Abhängigkeit des Sensorsignals,

- wobei die beiden PTC-Sensoren (PTC1, PTC2) so miteinander verschaltet sind, dass der Gesamtwiderstand der Sensorschaltung eine Kennlinie (PTC$_g$) aufweist, die im Bereich der Nennansprechtemperaturen (NAT1, NAT2) jeweils einen Wendepunkt (W1, W2) vorsieht,

**dadurch gekennzeichnet, dass** die Auswertungseinrichtung Mittel zur Ermittlung der Ableitung zweiter Ordnung des zeitabhängigen Sensorsignals ($d^2T/dt^2$, $d^2R/dt^2$, $d^2V/dt^2$) umfasst und ein Ausgangssignal generiert, wenn die Ableitung zweiter Ordnung des zeitabhängigen Sensorsignals einen vorgegebenen Schwellenwert überschreitet.

2. Schutzschaltung nach Anspruch 1, **dadurch gekennzeichnet, dass** Auswertungseinrichtung Mittel zur Auswertung der Wendepunkte der Kennlinie umfasst.

3. Schutzschaltung nach Anspruch 1, **dadurch gekennzeichnet, dass** die Sensorschaltung (2) einen Festwiderstand zur Erzeugung der Wendepunkte aufweist.

4. Schutzschaltung nach Anspruch 1, **dadurch gekennzeichnet, dass** die beiden PTC-Sensoren (PTC1, PTC2) in Reihe geschaltet sind.

5. Schutzschaltung nach Anspruch 1, **dadurch gekennzeichnet, dass** die beiden PTC-Sensoren (PTC1, PTC2) parallel geschaltet sind.

6. Schutzschaltung nach Anspruch 1, **dadurch gekennzeichnet, dass** wenigstens zwei, vorzugsweise drei erste PTC-Sensoren (PTC1) und wenigstens zwei, vorzugsweise drei zweite PTC-Sensoren (PTC2) parallel oder in Reihe geschaltet sind.

7. Schutzschaltung nach Anspruch 1, **dadurch gekennzeichnet, dass** wenigstens ein dritter PTC-Sensor (PTC3) vorgesehen ist, der eine Nennansprechtemperatur (NAT3) aufweist, die größer als die Nennansprechtemperatur (NAT2) des zweiten PTC-Sensors (PTC2) ist.

8. Schutzschaltung nach Anspruch 1, **dadurch gekennzeichnet, dass** die wenigstens zwei PTC-Sensoren (PTC1, PTC2) parallel geschaltet sind und der zweite PTC-Sensor (PTC2) einen höheren Kaltwiderstandswert als der erste PTC-Sensor aufweist.

9. Schutzschaltung nach Anspruch 1, **dadurch gekennzeichnet, dass** die Kennlinie zwischen den beiden Wendepunkten (W1, W2) einen annährend linear ansteigenden Verlauf aufweist.

10. Schutzschaltung nach Anspruch 1, **dadurch gekennzeichnet, dass** die Auswertungseinrichtung zur Auswertung des ansteigenden Verlaufs der Kennlinie zwischen den beiden Nennansprechtemperaturen ausgebildet ist.

11. Schutzschaltung nach Anspruch 1, **dadurch gekennzeichnet, dass** die Auswertungseinrichtung Mittel zur Ermittlung der Ableitung erster Ordnung des zeitabhängigen Sensorsignals (dT/dt, dR/dt, dV/dt) umfasst.

12. Schutzschaltung nach einem oder mehreren der vorhergehenden Ansprüche, **dadurch gekennzeichnet, dass** die Auswertungseinrichtung ein Ausgangssignal generiert, wenn das Sensorsignal einen vorgegebenen Schwellenwert überschreitet.

13. Schutzschaltung nach Anspruch 1, **dadurch gekennzeichnet, dass** die Auswertungseinrichtung Mittel zur Anpassung eines Schwellenwerts in Abhängigkeit der Ableitung erster und/oder zweiter Ordnung des zeitabhängigen Sensorsignals aufweist.

14. Schutzschaltung nach einem oder mehreren der vorhergehenden Ansprüche, **dadurch gekennzeichnet, dass** die Auswertungseinrichtung (3) ein Ausgangssignal generiert, wenn die Ableitung erster Ordnung des zeitabhängigen Sensorsignals einen vorgegebenen Schwellenwert überschreitet.

**Claims**

1. Protection device for electric motors (1) with

   - a sensor circuit (2) with at least one first PTC sensor (PTC1), at least one second PTC sensor (PTC2), whose nominal response temperature (NAT2) is greater than the nominal response temperature (NAT1) of the first PTC sensor, and
   - a tripping unit (3) with an evaluation device to evaluate the sensor signal arising based on the total resistance of the sensor circuit and to generate an output signal for the tripping unit as a function of the sensor signal,
   - whereby both PTC sensors (PTC1, PTC2) are connected with each other here in such a way that the total resistance of the sensor circuit exhibits a characteristic curve ($PTC_g$) which provides an inflexion point (W1, W2) in each case in the region of the nominal response temperatures (NAT1, NAT2),

   **characterised in that** the evaluation device comprises means to determine the second order derivative of the time-dependent sensor signal ($d^2T/dt^2$, $d^2R/dt^2$, $d^2V/dt^2$) and generates an output signal if the second order derivative of the time-dependent sensor signal exceeds a prescribed threshold value.

2. Protection device in accordance with claim 1, **characterised in that** the evaluation device comprises means to determine the inflexion points of the characteristic curve.

3. Protection device in accordance with claim 1, **characterised in that** the sensor circuit (2) has a fixed value resistor to generate the inflexion points.

4. Protection device in accordance with claim 1, **characterised in that** both PTC sensors (PTC1, PTC2) are connected in series.

5. Protection device in accordance with claim 1, **characterised in that** both PTC sensors (PTC1, PTC2) are connected in parallel.

6. Protection device in accordance with claim 1, **characterised in that** at least two, preferably three first PTC sensors (PTC1) and at least two, preferably three second PTC sensors (PTC2) are connected in parallel or in series.

7. Protection device in accordance with claim 1, **characterised in that** a third PTC sensor (PTC3) is provided which has a nominal response temperature (NAT3) which is greater than the nominal response temperature (NAT2) of the second PTC sensor (PTC2).

8. Protection device in accordance with claim 1, **characterised in that** the at least two PTC sensors (PTC1, PTC2) are connected in parallel and the second PTC sensor (PTC2) has a higher cold resistance value than the first PTC sensor.

9. Protection device in accordance with claim 1, **characterised in that** the characteristic curve between the two inflexion points (W1, W2) has an almost linearly rising form.

10. Protection device in accordance with claim 1, **characterised in that** the evaluation device is designed to evaluate the rising form of the characteristic curve between the two nominal response temperatures.

11. Protection device in accordance with claim 1, **characterised in that** the evaluation device has means of determining the first order derivative of the time-dependent sensor signal (dT/dt, dR/dt, dV/dt).

12. Protection device in accordance with one or more of the foregoing claims, **characterised in that** the evaluation device generates an output signal if the sensor signal exceeds a prescribed threshold value.

13. Protection device in accordance with claim 1, **characterised in that** the evaluation device has means of adapting a threshold value as a function of the first and / or second order derivative of the time-dependent sensor signal.

14. Protection device in accordance with one or more of the foregoing claims, **characterised in that** the evaluation device (3) generates an output signal if the first order derivative of the time-dependent sensor signal exceeds a prescribed threshold value.

**Revendications**

1. Dispositif de protection pour des moteurs électriques (1), comprenant

   - un circuit de capteurs (2) comportant au moins un premier capteur CTP (CTP1), au moins un deuxième capteur CTP (CTP2) dont la température de réaction nominale (NAT2) est supérieure à la température de réaction nominale (NAT1) du premier capteur CTP, ainsi
   - qu'un appareil déclencheur (3) comprenant un dispositif d'exploitation servant à l'exploitation du signal de capteur résultant de la résistance totale du circuit de capteurs et servant à la production d'un signal de sortie pour l'appareil déclencheur, en fonction du signal de capteur,
   - où les deux capteurs CTP (CTP1, CTP2) sont connectés l'un à l'autre de manière telle, que la résistance totale du circuit de capteurs présente une courbe caractéristique (CTPg) qui, dans la zone des températures de réaction nominales (NAT1, NAT2), prévoit à chaque fois un point d'inflexion (W1, W2),

   **caractérisé en ce que** le dispositif d'exploitation comprend des moyens servant à déterminer la dérivée de second ordre du signal de capteur ($d^2T/dt^2$, $d^2R/dt^2$, $d^2V/dt^2$ variable en fonction du temps et génère un signal de sortie lorsque la dérivée de second ordre du signal de capteur variable en fonction du temps dépasse une valeur de seuil prédéfinie.

2. Circuit de protection selon la revendication 1, **caractérisé en ce que** le dispositif d'exploitation comprend des moyens servant à l'exploitation des points d'inflexion de la courbe caractéristique.

3. Circuit de protection selon la revendication 1, **caractérisé en ce que** le circuit de capteurs (2) présente une résistance fixe servant à la production des points d'inflexion.

4. Circuit de protection selon la revendication 1, **caractérisé en ce que** les deux capteurs CTP (CTP1, CTP2) sont montés en série.

5. Circuit de protection selon la revendication 1, **caractérisé en ce que** les deux capteurs CTP (CTP1, CTP2) sont montés en parallèle.

6. Circuit de protection selon la revendication 1, **caractérisé en ce qu'**au moins deux, de préférence trois premiers capteurs CTP (CTP1) et au moins deux, de préférence trois deuxièmes capteurs CTP (CTP2) sont montés en parallèle ou en série.

7. Circuit de protection selon la revendication 1, **caractérisé en ce qu'**il est prévu au moins un troisième capteur CTP (CTP3) qui présente une température de réaction nominale (NAT3) qui est supérieure à la température de réaction nominale (NAT2) du deuxième capteur CTP (CTP2).

8. Circuit de protection selon la revendication 1, **caractérisé en ce que** les capteurs CTP (CTP1, CTP2), au moins au nombre de deux, sont montés en parallèle, et le deuxième capteur CTP (CTP2) présente une valeur de résistance à froid supérieure à celle du premier capteur CTP.

9. Circuit de protection selon la revendication 1, **caractérisé en ce que** la courbe caractéristique présente un profil ascendant presque linéaire, entre les deux points d'inflexion (W1, W2).

10. Circuit de protection selon la revendication 1, **caractérisé en ce que** le dispositif d'exploitation servant à l'exploitation du profil ascendant de la courbe caractéristique est configuré entre les deux températures de réaction nominales.

11. Circuit de protection selon la revendication 1, **caractérisé en ce que** le dispositif d'exploitation comprend des moyens servant à déterminer la dérivée de premier ordre du signal de capteur (dT/dt, dR/dt, dV/dt) variable en fonction du temps.

12. Circuit de protection selon l'une quelconque ou plusieurs des revendications précédentes, **caractérisé en ce que** le dispositif d'exploitation génère un signal de sortie lorsque le signal de capteur dépasse une valeur de seuil prédéfinie.

13. Circuit de protection selon la revendication 1, **caractérisé en ce que** le dispositif d'exploitation présente des moyens servant à l'adaptation d'une valeur de seuil, en fonction de la dérivée de premier et/ou de second ordre du signal de capteur variable en fonction du temps.

14. Circuit de protection selon l'une quelconque ou plusieurs des revendications précédentes, **caractérisé en ce que** le dispositif d'exploitation (3) génère un signal de sortie lorsque la dérivée de premier ordre du signal de capteur variable en fonction du temps dépasse une valeur de seuil prédéfinie.

Fig. 1

Fig. 2

Fig. 3

Fig. 4a

Fig. 4b

Fig. 4c

Fig. 5a

Fig. 5b

Fig. 5c

Fig. 6a

Fig. 6b

Fig. 7a

Fig. 7b

Fig. 8

Fig. 9

EP 2 187 494 B1

Fig. 10

Fig. 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19540625 B4
- DE 19822056 A1
- US 3644864 A